# EUROPÄISCHE PATENTANMELDUNG

(11) **EP 1 213 827 A2**
(43) Veröffentlichungstag der Anmeldung: **12.06.2002**
(21) Anmeldenummer: 01250429.6
(22) Anmeldetag: 06.12.2001
(51) Int. Cl.: H02M 7/538

(54) **Überstrom-Erfassungseinrichtung**

(30) Priorität: 06.12.2000 DE 10060553
(71) Anmelder: Bombardier Transportation GmbH, 13627 Berlin (DE)
(72) Erfinder: Etter, Peter, 5422 Oberehrendingen (CH); Jörg, Pieder, 7013 Domat/Ems (CH)
(74) Vertreter: Meyer, Hans-Joachim

(57) **Zusammenfassung**

Die vorliegende Erfindung offenbart eine Überstrom-Erfassungseinrichtung, mit der Überströme, die zu einer Zerstörung von abschaltbare Halbleiterbauelementen führen könnten, schnell und zuverlässig gemessen und dadurch die Zerstörung des Halbleiterbauelemente verhindert werden kann, ohne dass Gesamtströme im kA-Bereich gemessen werden müssen. Dazu wird in einer Parallelschaltung aus einem abschaltbaren Mess-Halbleiterbauelement (T_{M1}, T_{M2}) und mindestens einem abschaltbaren lasttragenden Halbleiterbauelement (T_{L1}, T_{L2}) im Strommesspfad eine Strommesseinrichtung (1) ausgebildet. Zudem ist antiparallel zum abschaltbaren lasttragenden Halbleiterbauelement (T_{L1}, T_{L2}) eine Freilaufdiode (D_{L1}, D_{L2}) ausgebildet. Als zwei alternative Ausführungsformen umfasst die erfindungsgemässe Überstrom-Erfassungseinrichtung entweder einen Nebenschlusswiderstand (R_{S}) mit einem Sättigungstransistor als Basisverstärker bzw. einen Nebenschlusswiderstand (R_{S}) mit einem Emitterfolger. Hierzu ist im mindestens einen Lastzweig parallel zum abschaltbaren lasttragenden Halbleiterbauelement jeweils das abschaltbare Mess-Halbleiterbauelement (T_{M1}, T_{M2}) ausgebildet, mit dessen Emitter der Nebenschlusswiderstand (R_{S}) verbunden ist. Zwischen dem Emitter des abschaltbaren Mess-Halbleiterbauelements (T_{M1}, T_{M2}) und dem Nebenschlusswiderstand (R_{S}) ist entweder die Basis eines Bipolartransistors (T₃, T₄) oder der Emitter eines Bipolartransistors angeschlossen. Auf diese Weise wird eine Verschaltung mit einem Sättigungstransistor als Basisverstärker oder mit Emitterfolger verwirklicht, durch die eine verzögerungsfreie Messung mit geringerer Belastung des abschaltbaren Mess-Halbleiterbauelements und verringertem Einfluss von Rauschen ermöglicht wird.

## Beschreibung

Die Erfindung bezieht sich auf das Gebiet der Leistungselektronik, insbesondere auf das Gebiet der Hochstrom-Module und eine Überstrom-Erfassungseinrichtung, insbesondere für Hochstrom-Module mit abschaltbaren Halbleiterbauelementen.

Aus der DE 196 33 542 A1 ist ein Leistungsmodul zur Verwendung bei einem Stromrichter zur Umwandlung von Gleichstromleistung in Gleichstrom- oder Wechselstromleistung und umgekehrt bekannt, das einen Stromfühler als integralen Bestandteil enthält. Der Stromfühler besteht dabei aus einem Widerstand in Reihe mit einem IGBT (Insulated Gate Bipolartransistor bzw. Bipolartransistor mit isoliert angeordneter Gateelektrode).

Weiterhin ist aus der JP 8195411 A1 bekannt, Sicherungs(schmelz)streifen zu verwenden, um einen gegenwärtigen Strom-Pfad im Fall eines Kurzschlusses zu öffnen.

Zudem offenbart die EP 0 833 422 A2 eine Schutzschaltung für ein abschaltbares Halbleiterbauelement, in der zwischen jedem Halbleiterbauelement und einem Ausgangsanschluss ein irreversibler Kurzschlussstrombegrenzer ausgebildet ist, der im Falle eines Kurzschlusses durchschmilzt. Durch ein Durchbrechen der Kollektor-Gate- und Emitter-Gate-Übergänge liegt dann sowohl das Gate des Halbleiterbauelements im Pfad mit durchgeschmolzenem Kurzschlussstrombegrenzer als auch das damit verbundene Gate zumindest eines parallel liegenden Halbleiterbauelements beispielsweise auf der vollen positiven Versorgungsspannung. Dadurch wird das intakte Halbleiterbauelement durchgeschaltet und die in einem Zwischenkreis gespeicherte Energie wird darüber abgeleitet. Dies hat zwar in der Regel aufgrund der immer noch hohen Ströme eine Zerstörung auch des parallelen Halbleiterbauelements zur Folge, jedoch wird eine Explosion der Gesamtschaltung verhindert.

Weiterhin ist es aus der JP 10257779 A1 bekannt, ein integriertes Powermodul auszubilden, das mit einer Gateelektronik bzw. einem Gate-Drive und einer Steuereinrichtung zur Erfassung von Anormalitäten integriert ausgebildet ist. Diese Steuereinrichtung erfasst die Anwesenheit einer Anormalität aus den Ausgangssignalen einer ersten Vergleicherschaltung, die beurteilt, ob eine erfasste Spannung nahe der einer positiven Elektrode ist, und einer zweiten Vergleicherschaltung, die beurteilt, ob die erfasste Spannung nahe der einer negativen Elektrode ist, und die Ausgabe eines Zündsignals, das ein Ein- und Ausschalten eines Halbleiterelements zum Schalten steuert. Wenn eine Anormalität erfasst wird, wird das Schalten eines Halbleiterelements, das dem zu schaltenden Halbleiterelement gegenüber liegt, durch eine Abschaltschaltung abgeschaltet.

Diese vorstehend erwähnte, herkömmliche Steuereinrichtung ist derzeit die einzige funktionstüchtige Stromerfassungslösung für Module mit hoher Energie/hoher Spannung. Es ist derzeit auch die schnellste Lösung.

Alle vorstehend angeführten, herkömmlichen Strommessverfahren basieren auf der Idee der Messung des Gesamtstroms, der sich im kA-Bereich bewegen kann, was sehr aufwendig ist und Probleme bei der Messung mit sich bringen kann.

Daher ist es Aufgabe der vorliegenden Erfindung, eine Überstrom-Erfassungseinrichtung insbesondere für Module mit abschaltbaren Halbleiterbauelementen, insbesondere IGBTs zu schaffen, durch das Schädigungen von abschaltbaren Halbleiterbauelementen, insbesondere IGBTs, durch Überströme schnell und zuverlässig verhindert werden können, ohne sehr grosse Ströme im kA-Bereich messen zu müssen.

Erfindungsgemäss wird diese Aufgabe durch eine Überstrom-Erfassungseinrichtung mit den Merkmalen des Patentanspruchs 1 bzw. 4 gelöst. In den Unteransprüchen sind bevorzugte Weiterbildungen der Erfindung angegeben.

Mit der erfindungsgemässen Überstrom-Erfassungseinrichtung für abschaltbare Halbleiterbauelemente, insbesondere IGBTs, durch das ein Kurzschluss-Schutz erreicht werden soll, wird der Gesamtstrom verringert, indem die natürliche Stromverteilung zwischen den Halbleiterbauelementen genutzt wird.

Weitere Aufgaben, Merkmale und Vorteile der vorliegenden Erfindung werden aus der nachstehenden Beschreibung bevorzugter Ausführungsbeispiele der Erfindung in Verbindung mit der Zeichnung offensichtlich.

Es zeigen:
Fig. 1 eine Schaltung zur Strommessung mit zwei Zweigen mit jeweils einem Mess-IGBT und einem Last-IGBT,
Fig. 2 eine Analyse des statischen Verhaltens der Schaltung gemäss Fig. 1,
Fig. 3 Spannungsunterschiede Nennstrom-Kurzschlussstrom, Spitzenverlustleistung und mittlere Verlustleistung im Nebenschlusswiderstand für die Schaltung gemäss Fig. 1,
Fig. 4 eine Verlustleistung bzw. einen Spannungsabfall am Gate-Drive für verschiedenen Werte des Nebenschlusswiderstands in der Schaltung gemäss Fig. 1,
Fig. 5 ein Schaltbild eines ersten Ausführungsbeispiels der Erfindung mit einem Nebenschlusswiderstand mit einem in das Modul integrierten Emitterfolger,
Fig. 6 ein Schaltbild eines zweiten Ausführungsbeispiels der Erfindung mit einem Nebenschlusswiderstand mit einem in das Modul integrierten Sättigungstransistor als Basisverstärker,
Fig. 7 das statische Verhalten der Schaltung gemäss Fig. 6,
Fig. 8 das Einschaltverhalten und Umschalten in einen Kurzschluss für die Schaltung gemäss Fig. 6 und
Fig. 9 ein Schaltbild, das das erfindungsgemässe Prinzip einer Stromaufteilung zwischen den IGBT-Bausteinen zeigt,

Zum zuverlässigen Schutz von abschaltbaren Halbleiterbauelementen vor Beschädigungen durch Überströme wurden bisher generell die Gesamtströme gemessen. Dies gestaltete sich schwierig, da es sich hierbei um Ströme im kA-Bereich handelt.

Daher soll die vorliegende erfindung eine Überstrom-Erfassungseinrichtung zur Verfügung stellen, bei der keine Messung des Gesamtstroms erforderlich ist und dennoch zuverlässige Ergebnisse erzielt werden.

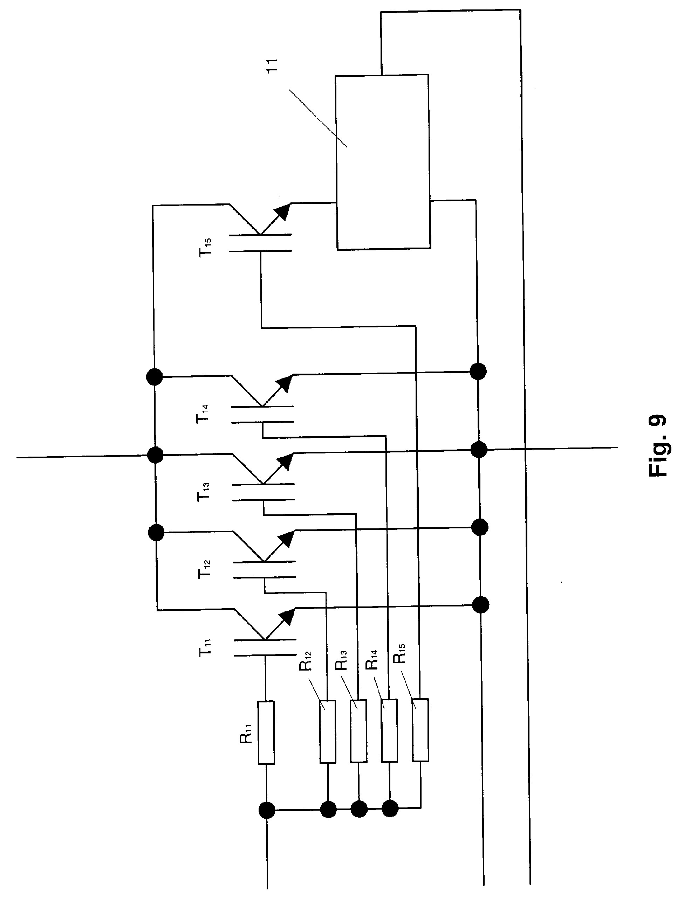

Um dieses Ziel zu erreichen, verwendet die erfindungsgemässe Überstrom-Erfassungseinrichtung eine Stromaufteilung zwischen parallel geschalteten abschaltbaren Halbleiterbauelementen, beispielsweise IGBT-Bausteinen, um den zu messenden Maximalstrom zu verringern. Eine Prinzip-Schaltung mit einer derartigen Stromaufteilung ist in Fig. 9 gezeigt. In einer derartigen Schaltung sind beispielsweise fünf abschaltbare Halbleiterbaulemente T₁₁ bis T₁₅, z.B. Transistoren mit isoliertem Gate (IGBT) jeweils mit einem Widerstand R₁₁ bis R₁₅ vor dem isolierten Gateanschluss angeordnet. Die Kollektoranschlüsse dieser Transistoren T₁₁ bis T₁₅ sind miteinander elektrisch verbunden. Einer der Transistoren mit isoliertem Gate T₁₅ wird als Mess-Transistor verwendet, hinter dessen Emitteranschluss eine Schutzeinrichtung 11 angeordnet ist. Mittels dieser Aufteilung des Stroms auf fünf parallele Zweige wird der zu messende Strom bedeutend verringert. Bei einer derartigen Schaltung zur Strommessung werden immer zusätzliche Elemente im Emissionspfad angeordnet, so dass sie auf demselben Potential sind wie die Gateelektronik bzw. das Gate-Drive.

Für eine Untersuchung der erfindungsgemässen Überstrom-Erfassungseinrichtung gemäss dem vorstehenden Prinzip wurde als abschaltbares Halbleiterbauelement ein 50A IGBT-Baustein verwendet; die vorliegende Erfindung ist jedoch auch auf andere abschaltbare Halbleiterbauelemente anwendbar. Der Spannungswert stand nicht zur Diskussion, da das abschaltbare Halbleiterbauelement, beispielsweise der IGBT, der einzige spannungsabhängige Teil in der Schaltung ist.

Im folgenden wird nun eine erfindungsgemässe schnelle Überstrom-Erfassungseinrichtung für den ungünstigsten Fall einer Verwendung von nur zwei parallelen abschaltbaren Halbleiterbauelementen am Beispiel von IGBT-Bausteinen pro Zweig, von denen einer zur Strommessung verwendet wird, genauer beschrieben.

Zuerst wird auf die Stromaufteilung auf die zwei IGBT-Bausteine unter dem Gesichtspunkt der IGBT-Emitterpfadimpedanz eingegangen. Ein Einfügen eines Sensors in den Emitterpfad eines abschaltbaren Halbleiterbauelements beeinflusst nämlich immer die Stromaufteilung.

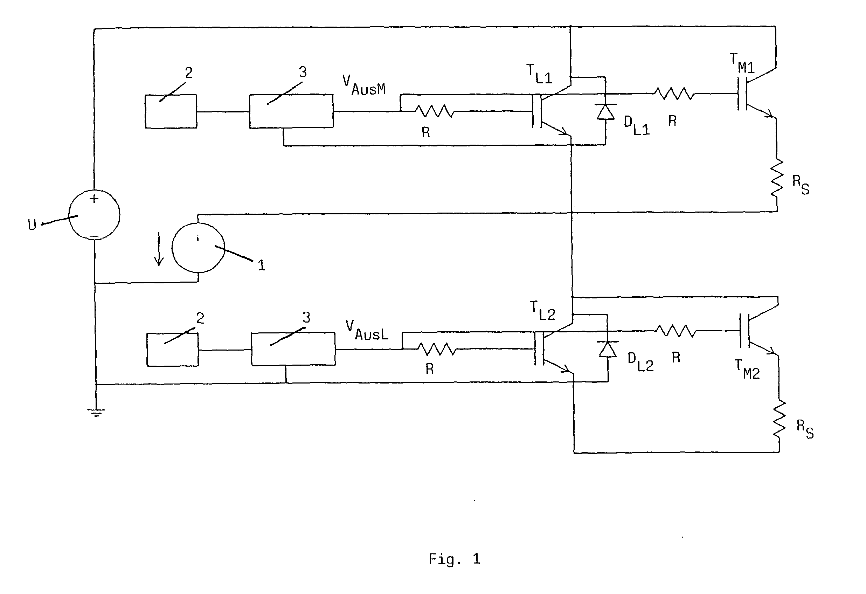

Fig. 1 zeigt eine Schaltung zur Strommessung, in der ein Mess-IGBT T_{M1}, T_{M2} parallel zu einem lasttragenden bzw. Last-IGBT T_{L1}, T_{L2} geschaltet ist. Im folgenden wird beispielhaft nur der obere Zweig (T_{L1}, T_{M1}) der Schaltung genauer beschrieben, wobei die Beschreibung jedoch auch für den unteren Zweig (T_{L2}, T_{M2}) zutrifft (, wobei hier lediglich Index 1 durch 2 zu setzen ist). Diese Schaltung zur Strommessung, die nur zwei IBGT-Bausteine T_{L1}, T_{M1} aufweist, wird als der schlimmste Fall angesehen, da er zur messende Strom den höchstmöglichen Wert besitzt. Der Effekt verringert sich bei der Verwendung mehrerer Last-IGBT in seiner Deutlichkeit; daher erfolgt die Erläuterung der Erfindung nachfolgend anhand dieses Extrembeispiels. Für eine Analyse wurde ein Nebenschlusswiderstand R_{S} mit Werten von 0,01Ω bis 10Ω gewählt. In dieser Schaltung sind die beiden Verschaltungen für die IGBT-Bausteine T_{M1} und T_{L1} identisch, bis auf den Unterschied, dass im Pfad, in dem die Strommessung durchgeführt wird, zusätzlich ein Sensor bzw. eine Strommesseinrichtung 1 ausgebildet ist. In jeder der Verschaltungen der IGBT-Bausteine T_{M1}, T_{L1} wird ein Bit-Strom 2 einer Gateelektronik bzw. einem Gate-Drive 3 zugeführt, das daraufhin ein Spannungsausgangssignal V_{AusM}, V_{AusL} erzeugt, das über einen Widerstand R, beispielsweise 10Ω, an das Gate des IGBT T_{M1} bzw. T_{L1} angelegt wird. Parallel zum IGBT T_{L1} ist eine Freilaufdiode D_{L1} ausgebildet. Zudem ist eine Spannungsquelle U ausgebildet, die beispielsweise eine Spannung von 2800 V ausgibt. Zusätzlich wird das Spannungsausgangssignal V_{AusM}, V_{AusL} des Gate-Drive 3 über einen weiteren Widerstand R (beispielsweise 10 Ω) einem Gate eines Mess-IGBT T_{M1} zugeführt, dessen Emitteranschluss über einen Nebenschlusswiderstand R_{S} mit dem Emitteranschluss des Last-IGBT T_{L1} verbunden ist. Durch diesen vorstehend beschriebenen Aufbau der Schaltung wird eine Aufteilung des Stroms auf die zwei IGBT-Bausteine T_{M1} bzw. T_{L1} erreicht. Bei einer Verwendung mehrerer Last-IGBT parallel zueinander anstelle des einzelnen Last-IGBT T_{L1} verringert sich der Strom pro parallel geschaltetem IGBT entsprechend.

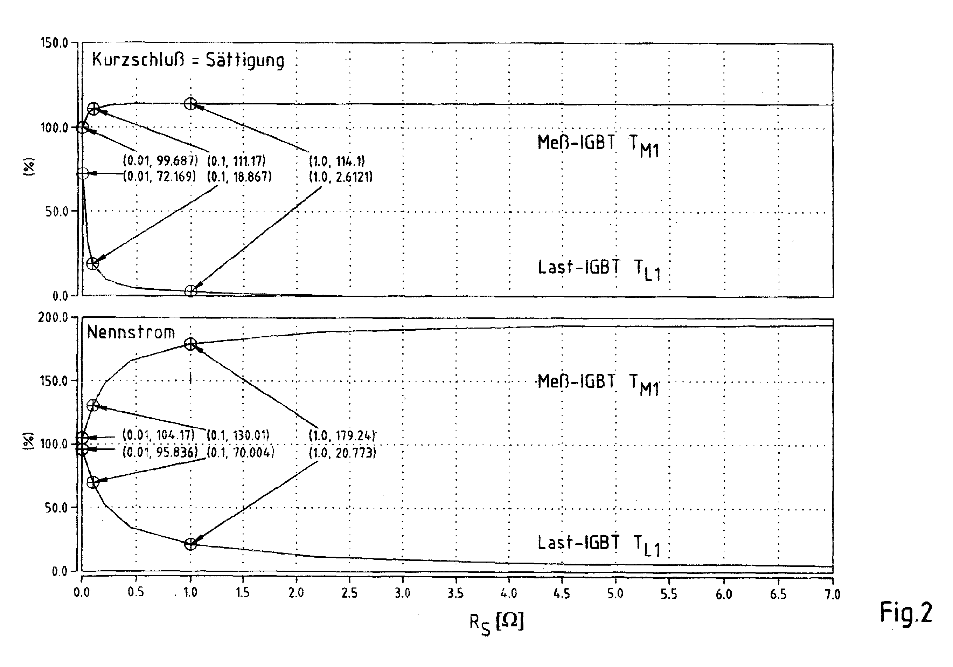

Das statische Verhalten dieser Schaltung zur Strommessung wird nachfolgend unter Bezugnahme auf Fig. 2 analysiert. Aus Fig. 2 ist für den Fall eines lasttragenden bzw. Last-IGBT T_{L1} sowie eines Mess-IGBT T_{M1} ein relatives statisches Stromungleichgewicht für einen gegebenen Nebenschlusswiderstand R_{S} in einem Emitterpfad gezeigt. Insbesondere ist hieraus die Abweichung vom Nennstrom bzw. vom gleichmässig verteilten Sättigungsstrom ersichtlich.

Fig. 2 zeigt die Stromverteilung zwischen Last-IGBT T_{L1} und Mess-IGBT T_{M1}. Hierbei bezieht sich die obere Hälfte der Figur auf eine Kurzschlussbedingung, d.h. eine Sättigung, während die untere Hälfte der Figur die Situation bei Nennstrom veranschaulicht, jeweils aufgetragen gegen die Grösse des Nebenschlusswiderstands R_{S}, der zwischen 0,01 Ω und 10 Ω gewählt wurde.

Wie aus Fig. 2 ersichtlich, wird das Stromungleichgewicht für Nebenschlusswiderstände R_{S} über 1Ω wesentlich. Dies kann jedoch auch verwendet werden, um den Strom für den Nebenschlusswiderstand R_{S} herunterzubrechen, wodurch sein Leistungsverbrauch (power rating) verringert wird. Es muss natürlich garantiert werden, dass der Nebenschlusswiderstand R_{S} immer noch einen proportionalen Strom sieht, der ihm erlaubt, einen Kurzschluss zu erfassen.

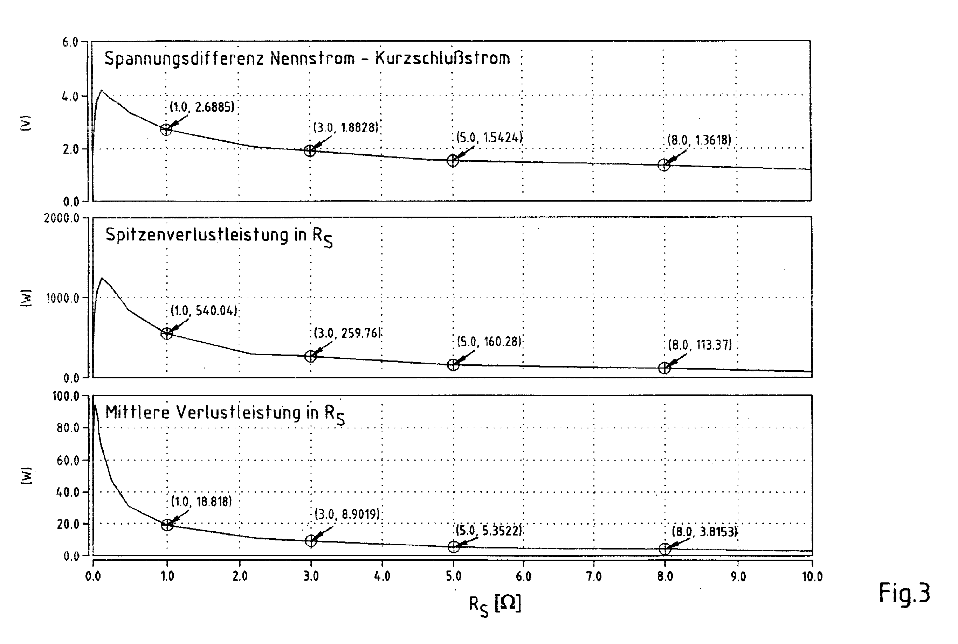

Fig. 3 zeigt im obersten Diagramm einen Spannungsunterschied über den Nebenschlusswiderstand R_{S} für den Nennbetrieb und für Sättigung. Beispielsweise ist für R_{S} = 1Ω die Spannung über den Nebenschlusswiderstand R_{S} bei einem Kurzschluss 2,6885V höher als im Nennbetrieb. Dies wäre für eine Erfassung ausreichend. Die zwei anderen Graphen zeigen die angenommene Spitzenleistung im Nebenschlusswiderstand R_{S} und die mittlere Verlustleistung im Nebenschlusswiderstand R_{S}.

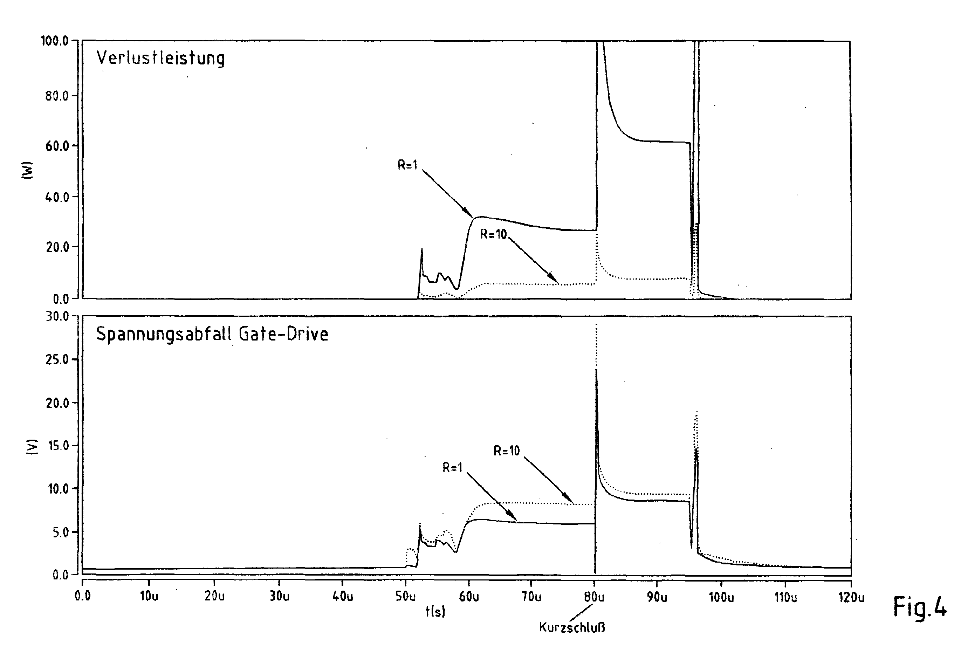

Fig. 4 zeigt für den Nebenschlusswiderstand R_{S} eine Verlustleistung (obere Kurve) bzw. einen gemessenen Spannungsabfall im Gate-Drive (untere Kurve) für den Fall eines Einschaltens auf 50% des Nennstroms und dann nach 80µs einen Kurzschluss, jeweils für zwei verschiedene Nebenschlusswiderstände R_{S} von 1Ω bzw. 10Ω.

Aufgrund der vorstehend beschriebenen Ergebnisse werden erfindungsgemäss zwei verschiedene Prinzipien für eine Schaltung zur Strommessung vorgeschlagen.

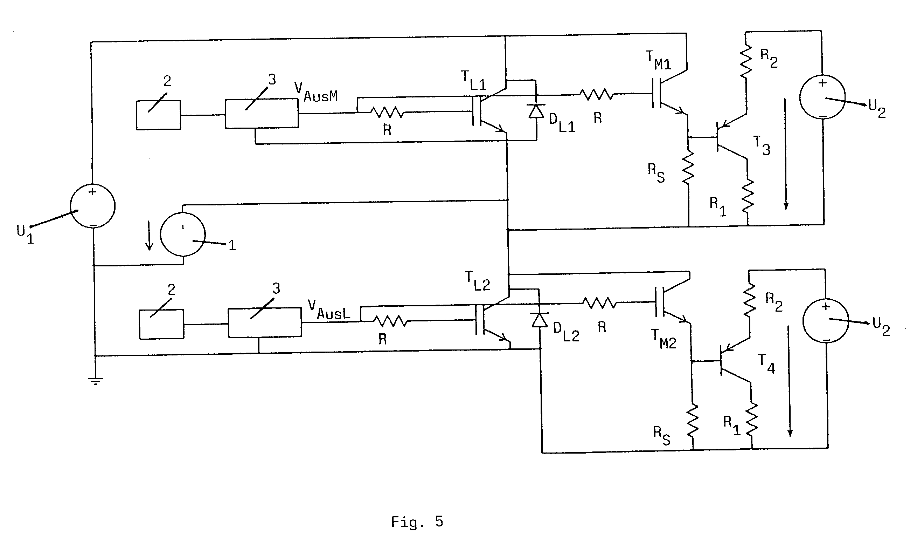

Gemäss einem ersten Ausführungsbeispiel der Erfindung ist die Verwendung eines Nebenschlusswiderstands mit Emitterfolger vorgeschlagen. Hierbei ist die Spannung über den Nebenschlusswiderstand relativ klein und kann leicht durch Rauschen beeinträchtigt werden. Daher ist es sehr wichtig, das Signal auf einen Pfad mit niedrigem Widerstand zu leiten. Das erste Ausführungsbeispiel der Erfindung besteht in einem in ein Modul integrierten Emitterfolger, wie in Fig. 5 gezeigt. Hierbei ist die Schaltung wie folgt aufgebaut: Der Mess-IGBT T_{M1} ist parallel zu einem lasttragenden bzw. Last-IGBT T_{L1} geschaltet. Die beiden Verschaltungen für die IGBT-Bausteine T_{M1} und T_{L1} sind identisch, bis auf den Unterschied, dass im Pfad, in dem die Strommessung durchgeführt wird, zusätzlich ein Sensor bzw. eine Strommesseinrichtung 1 ausgebildet ist. In jeder der Verschaltungen der IGBT-Bausteine T_{M1}, T_{L1} wird ein Bit-Strom 2 einer Gateelektronik bzw. einem Gate-Drive 3 zugeführt, das daraufhin ein Spannungsausgangssignal V_{AusM}, V_{AusL} erzeugt, das über einen Widerstand R (beispielsweise 10 Ω) an das Gate des Last-IGBT T_{L1} angelegt wird. Parallel zum Last-IGBT T_{L1} ist eine Freilaufdiode D_{L1} ausgebildet. Zudem ist eine Spannungsquelle U₁ ausgebildet, die beispielsweise eine Spannung von 2800 V ausgibt. Zusätzlich wird das Spannungsausgangssignal V_{AusM} bzw. V_{AusL} des Gate-Drive 3 über einen weiteren Widerstand R (z.B. 10 Ω) einem Gate eines Mess-IGBT T_{M1} zugeführt, dessen Emitteranschluss über einen Nebenschlusswiderstand R_{S} mit dem Last-IGBT T_{L1} verbunden ist. Ausserdem ist zwischen dem Emitter und dem Nebenschlusswiderstand R_{S} eine Basis eines PNP-Transistors T₃ bzw. T₄ angeschlossen, dessen Emitter über einen Widerstand R₂ (beispielsweise 100 kΩ) mit dem positiven Ausgang einer Spannungsquelle U₂ (z.B. 22,5 V) verbunden ist, während der Kollektor über einen Widerstand R₁ (z.B. 1 kΩ) sowohl mit dem negativen Ausgang der Spannungsquelle U₂ als auch dem Emitter des Last-IGBT T_{L1} verbunden ist.

Durch die Verwendung des Emitterfolgers, der ohne das Erfordernis einer internen Stromversorgung als ein Open-Kollektor verwendet werden kann, liegt vorteilhafterweise die Antwortspannung am Anschluss immer um 0,7 V höher als die Basisspannung des NPN-Transistors, so dass negative Einflüsse von Rauschen verringert werden. Aus diesem Grund kann ein regulärer Bipolar-Kleinsignaltransistor als Transistor T₃ bzw. T₄ verwendet werden.

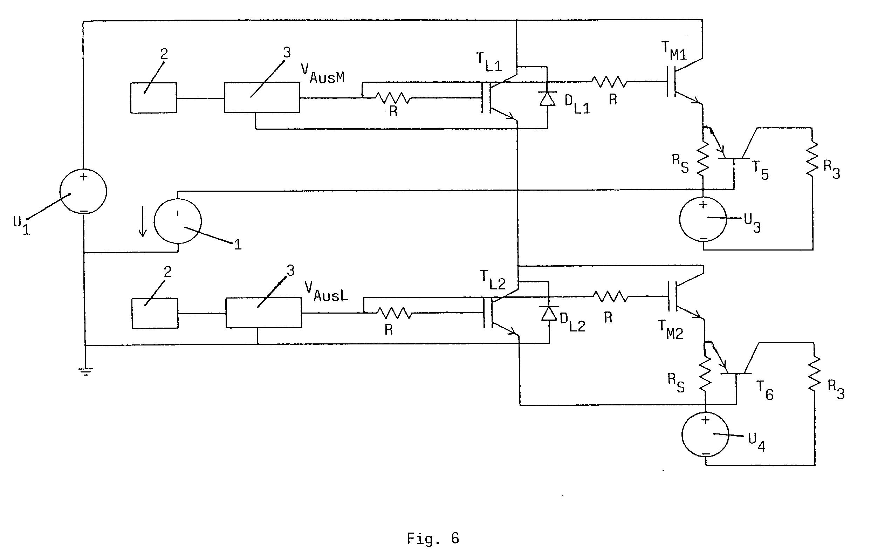

Alternativ wird in einem zweiten Ausführungsbeispiel der Erfindung ein Nebenschlusswiderstand R_{S} mit einem Sättigungstransistor als Basisverstärker zu verwendet. Diese Schaltung ist in Fig. 6 gezeigt. Hier ist der Mess-IGBT T_{M1} parallel zu einem lasttragenden bzw. Last-IGBT T_{L1} geschaltet. Die beiden Verschaltungen für die IGBT-Bausteine T_{M1} und T_{L1} sind identisch, bis auf den Unterschied, dass im Pfad, in dem die Strommessung durchgeführt wird, zusätzlich ein Sensor bzw. eine Strommesseinrichtung 1 ausgebildet ist. In jeder der Verschaltungen der IGBT-Bausteine T_{M1} bzw. T_{L1} wird ein Bit-Strom 2 einer Gateelektronik bzw. einem Gate-Drive 3 zugeführt, das daraufhin ein Spannungsausgangssignal V_{AusM}, V_{AusL} erzeugt, das über einen Widerstand R (beispielsweise 10 Ω) an das Gate des Last-IGBT T_{L1} angelegt wird. Parallel zum Last-IGBT T_{L1} ist eine Freilaufdiode D_{L1} ausgebildet. Zudem ist eine Spannungsquelle U₁ ausgebildet, die beispielsweise eine Spannung von 2800 V ausgibt. Zusätzlich wird das Spannungsausgangssignal V_{AusM} bzw. V_{AusL} des Gate-Drive 3 über einen weiteren Widerstand R (z.B. 10 Ω) einem Gate eines Mess-IGBT T_{M1} zugeführt, deren Emitteranschluss über einen Nebenschlusswiderstand R_{S} mit dem Emitteranschluss des Last-IGBT T_{L1} verbunden ist. Ausserdem ist zwischen dem Emitter und dem Nebenschlusswiderstand R_{S} ein Emitter eines PNP-Transistors T₅ bzw. T₆ angeschlossen, dessen Basis mit einem Emitter des Last-IGBT T_{L} sowie einem positiven Ausgang einer Spannungsquelle U₃ bzw. U₄ (Gate-Drive-Versorgungsspannung) verbunden ist. Hierbei ist beispielsweise U₃ = 7,5 V und U₄ = 22,5 V, diese Spannungen können jedoch unabhängig von der hier beschriebenen Erfassungsvorrichtung gewählt werden, um verlust-optimierten Normalbetrieb der IGBTs im zu ermöglichen. Zwischen dem negativen Anschluss der Spannungsquelle U₃ bzw. U₄ und dem Kollektoranschluss des PNP-Transistors T₅ bzw. T₆ ist zudem ein Widerstand (z.B. R = 1kΩ) ausgebildet.

Bei dieser vorstehend beschriebenen Schaltung wird die Nebenschlusswiderstands-Spannung durch einen PNP-Transistor T₅ bzw. T₆ verstärkt, der in einer Basisbeschaltung betrieben wird. Die Schaltung ist derart entworfen, dass der Bipolar-(Kleinsignal-)Transistor T₅ bzw. T₆ gesättigt ist, wann immer der Last-IGBT T_{L1} zu viel Strom führt. Dies ergibt eine sehr scharfe Spannungsantwort. Hier muss allerdings die Spannungsantwort gegen die negative Gate-Drive-Versorgungsspannung gemessen werden.

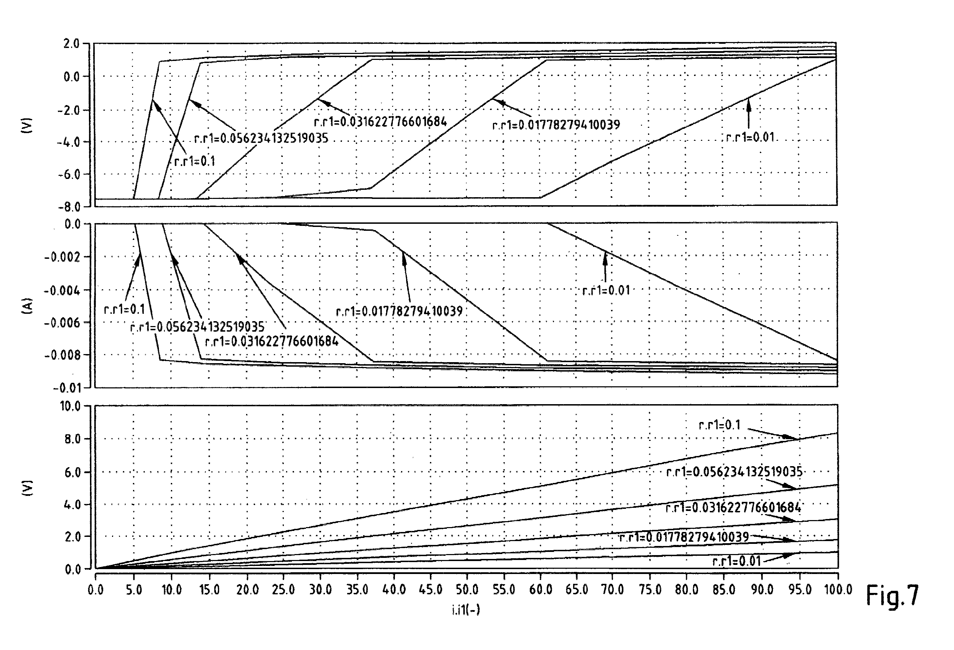

Fig. 7 zeigt das statische Verhalten dieser Nebenschlusswiderstandsanordnung mit einem in Sättigung gehenden Basisverstärker gemäss Fig. 6. Der oberste Graph zeigt die Antwortspannung am Ausgang (Kollektor) des Verstärkers T₅. Der zweite Graph zeigt den in dem Modul fliessenden Strom, der tatsächlich aus dem Modul zur negativen Gate-Drive-Versorgungsspannung U₃ hin fliesst. Der unterste Graph zeigt die Spannung über den Nebenschlusswiderstand R_{S}. Der Parameter ist in allen Graphen der Gesamt-Nebenschlusswiderstand R_{S}, wobei der Beitrag des Transistors T₅ nicht berücksichtigt wird.

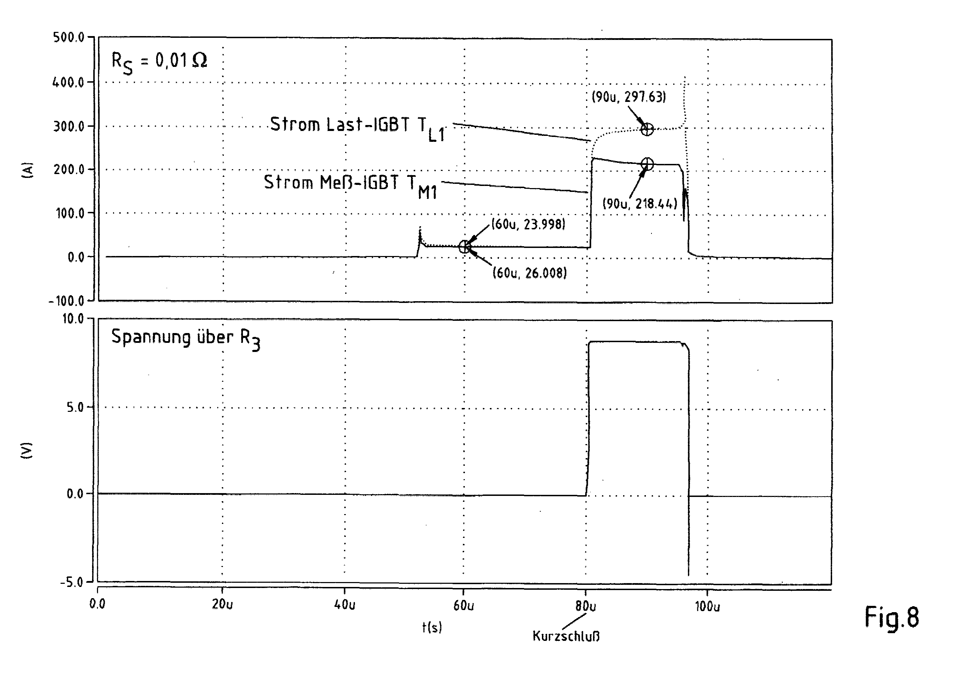

Fig. 8 zeigt wiederum für die Schaltung gemäss Fig. 6 den Strom- und Spannungsverlauf beim Einschalten und Umschalten auf einen Kurzschluss nach 80 µs als Antwort des Basisverstärkers T₅ für einen Nebenschlusswiderstand R_{S}. = 0,01 Ω. Der obere Graph verdeutlich die Stromaufteilung zwischen lasttragendem bzw. Last-IGBT T_{L1} und Mess-IGBT T_{M1}. Hieraus ist ersichtlich, dass bei Nennstrom, d.h. unter normalen Bedingungen beide IGBTs ungefähr den identischen gegenwärtigen Strom aufweisen, während im Fall der Sättigung der Mess-IGBT T_{M1} weniger Strom zieht (in Fig. 8 gestrichelt dargestellt), wobei hier immer der ungünstigste Fall der Verwendung nur eines Last-IGBT T_{L1} und eines Mess-IGBT T_{M1} betrachtet wird. Der untere Graph zeigt die Mess-Antwort, d.h. die Spannung über einen Mess-Widerstand R₃, wobei diese Spannung gegen die negative Gate-Drive-Versorgungsspannung U₃ von -7,5V gemessen wird. Die Reaktion ist im wesentlichen verzögerungsfrei und hängt nur vom Pegel ab, auf den sie angepasst wurde.

Zusammenfassend offenbart die vorliegende Erfindung eine Überstrom-Erfassungseinrichtung, mit der Überströme, die zu einer Zerstörung von abschaltbaren Halbleiterbauelementen führen könnten, schnell und zuverlässig gemessen und dadurch die Zerstörung des Halbleiterbauelemente verhindert werden kann, ohne dass Gesamtströme im kA-Bereich gemessen werden müssen. Dazu wird in einer Parallelschaltung aus einem abschaltbaren Mess-Halbleiterbauelement und mindestens einem abschaltbaren lasttragenden Halbleiterbauelement im Strommesspfad eine Strommesseinrichtung ausgebildet. Zudem ist antiparallel zum abschaltbaren lasttragenden Halbleiterbauelement eine Freilaufdiode ausgebildet. Als zwei alternative Ausführungsformen umfasst die erfindungsgemässe Überstrom-Erfassungseinrichtung entweder einen Nebenschlusswiderstand mit einem Sättigungstransistor als Basisverstärker bzw. einen Nebenschlusswiderstand mit einem Emitterfolger. Hierzu ist im mindestens einen Lastzweig parallel zum abschaltbaren lasttragenden Halbleiterbauelement jeweils das abschaltbare Mess-Halbleiterbauelement ausgebildet, mit dessen Emitter ein Nebenschlusswiderstand verbunden ist. Zwischen dem Emitter des abschaltbaren Mess-Halbleiterbauelements und dem Nebenschlusswiderstand ist entweder die Basis eines Bipolartransistors oder der Emitter eines Bipolartransistors angeschlossen. Auf diese Weise wird eine Verschaltung mit einem Sättigungstransistor als Basisverstärker oder mit Emitterfolger verwirklicht, durch die eine verzögerungsfreie Messung mit geringerer Belastung des abschaltbaren Mess-Halbleiterbauelements und verringertem Einfluss von Rauschen ermöglicht wird.

## Patentansprüche

1. Überstromerfassungseinrichtung mit mindestens einem Schaltungszweig mit:
einem abschaltbaren Mess-Halbleiterbauelement (T_{M1}, T_{M2}) parallel zu mindestens einem abschaltbaren Last-Halbleiterbauelement (T_{L1}, T_{L2}),
einer Strommesseinrichtung (1) im Pfad des abschaltbaren Mess-Halbleiterbauelements (T_{M1}),
sowohl im Pfad des abschaltbaren Mess-Halbleiterbauelements (T_{M1}, T_{M2}) als auch im mindestens einen Pfad des abschaltbaren Last-Halbleiterbauelements (T_{L1}, T_{L2}):
einer gemeinsamen Einrichtung (2) zur Erzeugung eines Bitstroms, der einem gemeinsamen Gate-Drive (3) zugeführt wird, zur Ausgabe eines Spannungsausgangssignals (V_{AusM}, V_{AusL}) ansprechend auf den Bitstrom über einen ersten Widerstand (R) an das Gate des abschaltbaren Last-Halbleiterbauelements (T_{L1}, T_{L2}) und über einen zweiten Widerstand (R) an das Gate des abschaltbaren Mess-Halbleiterbauelements (T_{M1}, T_{M2}), dessen Emitteranschluss über einen Nebenschlusswiderstand (R_{S}) mit dem Emitteranschluss des abschaltbaren Last-Halbleiterbauelements (T_{L1}, T_{L2}) verbunden ist,
wobei zwischen dem Emitter des abschaltbaren Mess-Halbleiterbauelements (T_{M1}, T_{M2}) und dem Nebenschlusswiderstand (R_{S}) die Basis eines Transistors (T₃, T₄) angeschlossen ist, dessen Kollektor über einen dritten Widerstand (R₁) mit einem negativen Anschluss einer Spannungsquelle (U₂) und dem Emitter des abschaltbaren Last-Halbleiterbauelements (T_{L1}, T_{L2}) verbunden ist, während der Emitter über einen vierten Widerstand (R₂) mit einem positiven Anschluss der Spannungsquelle (U₂) verbunden ist.

2. Überstrom-Erfassungseinrichtung nach Anspruch 1, wobei
der erste und der zweite Widerstand (R) jeweils einen Wert von 10Ω aufweisen, während der dritte Widerstand (R₁) einen Wert von 1kΩ und der vierte Widerstand (R₂) einen Wert von 100 kΩ aufweisen.

3. Überstrom-Erfassungseinrichtung, mit mindestens einem Schaltungszweig mit:
einem abschaltbaren Mess-Halbleiterbauelement (T_{M1}, T_{M2}) parallel zu mindestens einem abschaltbaren Last-Halbleiterbauelement (T_{L1}, T_{L2}),
einer Strommesseinrichtung (1) im Pfad des abschaltbaren Mess-Halbleiterbauelements (T_{M1}),
sowohl im Pfad des abschaltbaren Mess-Halbleiterbauelements (T_{M1}, T_{M2}) als auch im mindestens einen Pfad des abschaltbaren Last-Halbleiterbauelements (T_{L1}, T_{L2}):
einer gemeinsamen Einrichtung (2) zur Erzeugung eines Bitstroms, der einem gemeinsamen Gate-Drive (3) zugeführt wird, zur Ausgabe eines Spannungsausgangssignals (V_{AusM}, V_{AusL}) ansprechend auf den Bitstrom über einen ersten Widerstand (R) an das Gate des abschaltbaren Last-Halbleiterbauelements (T_{L1}, T_{L2}) und über einen zweiten Widerstand (R) an das Gate des abschaltbaren Mess-Halbleiterbauelements (T_{M1}, T_{M2}), dessen Emitteranschluss über einen Nebenschlusswiderstand (R_{S}) sowohl mit einem positiven Anschluss einer Spannungsquelle (U₃, U₄) als auch mit dem Emitter des abschaltbaren Last-Halbleiterbauelementes (T_{L1}, T_{L2}) verbunden ist,
wobei zwischen dem Emitter des abschaltbaren Mess-Halbleiterbauelements (T_{M1}, T_{M2}) und dem Nebenschlusswiderstand (R_{S}) der Emitter eines Transistors (T₅, T₆) angeschlossen ist, dessen Kollektor über einen fünften Widerstand (R₃) mit einem negativen Anschluss der Spannungsquelle (U₃, U₄) verbunden ist, während die Basis des Transistors (T₅, T₆) sowohl mit dem positiven Anschluss der Spannungsquelle (U₃, U₄) als auch mit dem Emitter des abschaltbaren Last-Halbleiterbauelements (T_{L1}, T_{L2}) verbunden ist.

4. Überstrom-Erfassungseinrichtung nach Anspruch 3, wobei
der erste und der zweite Widerstand (R) jeweils einen Wert von 10Ω aufweisen, während der fünfte Widerstand (R₃) einen Wert von 1kΩ aufweist.

5. Überstrom-Erfassungseinrichtung nach einem der vorhergehenden Ansprüche 1 bis 4, wobei
der Nebenschlusswiderstand (R_{S}) einen Wert im Bereich zwischen 0,01Ω und 10Ω aufweist.

6. Überstrom-Erfassungseinrichtung nach einem der vorhergehenden Ansprüche 1 bis 5, wobei
als abschaltbare Halbleiterbauelemente Bipolartransistoren (T_{L1}, T_{M1}, T_{L2}, T_{M2}) mit isoliert angeordneter Gate-Elektrode verwendet werden.

7. Überstrom-Erfassungseinrichtung nach einem der vorhergehenden Ansprüche 1 bis 6, wobei
als Transistoren (T₃, T₄; T₅, T₆) Bipolar-Kleinsignaltransistoren verwendet werden.

8. Überstrom-Erfassungseinrichtung nach Anspruch 7, wobei
die Transistoren (T₃, T₄; T₅, T₆) PNP-Transistoren sind.
